# EUROPÄISCHE PATENTSCHRIFT

(11) **EP 2 479 861 B1**
(45) Veröffentlichungstag und Bekanntmachung des Hinweises auf die Patenterteilung: **14.12.2016**
(21) Anmeldenummer: 11151448.5
(22) Anmeldetag: 19.01.2011
(51) Int. Cl.: H02J 1/14, G06F 1/20, H05K 7/14, H05K 7/20

(54) **Automatisierungsgerät**
Automation device
Appareil d'automatisation

(43) Veröffentlichungstag der Anmeldung: 25.07.2012
(73) Patentinhaber: Siemens Aktiengesellschaft, 80333 München (DE)
(72) Erfinder: Abert, Michael, 76474 Au (DE); Cyron, Michael, 76187 Karlsruhe (DE); Klamm, Arnold, 76870 Kandel (DE); Kort, Valentin, 76829 Landau (DE)

(56) Entgegenhaltungen:
- EP-A1- 2 073 618
- EP-A1- 2 149 956
- US-A1- 2002 195 953

## Beschreibung

Die Erfindung betrifft ein Automatisierungsgerät gemäß dem Oberbegriff des Anspruchs 1.

Aus dem Siemens-Katalog ST PCS 7, Kapitel 6, Ausgabe Februar 2010 ist ein Automatisierungsgerät mit mehreren Modulen bekannt, die in Form von auf einem Träger angeordneten Baugruppen verwirklicht sind, welche jeweils innerhalb einer Gehäusekapsel eine mit elektrischen und elektronischen Bauteilen versehene Leiterplatte aufweisen. Die Entwärmung dieser Bauteile erfolgt im Wesentlichen durch Konvektion in der Art und Weise, dass Luft durch eine Öffnung auf der Unterseite der Gehäusekapsel über die Bauteile und schließlich durch eine Öffnung auf der Oberseite der Gehäusekapsel strömt, wobei die durch das Gehäuse strömende Luft den Bauteilen Wärme entzieht. Aufgrund derart konstruierter Baugruppen wird eine ausreichende Entwärmung nur dann ermöglicht, wenn der Träger horizontal bzw. die Baugruppen vertikal auf dem Träger angeordnet sind.

Um in einem Automatisierungsgerät die Konvektion zu verbessern, wird in der EP 2 073 618 A1 vorgeschlagen, über wärmeleitfähige Kontaktierungsmittel die jeweils in den Baugruppen entstehende Wärme einem um 90° abgewinkelten Teil auf der Rückseite eines Trägers zuzuführen. Dieser abgewinkelte Teil, welcher sich über die gesamte Länge des Trägers erstreckt, ist als Kühlkörper vorgesehen, auf welchem mit quadratischem Querschnitt versehene Luftkanäle aus nicht Wärme speicherndem Material angeordnet sind, wodurch eine im Wesentlichen laminare Luftströmung in den Luftkanälen erzielt, Verwirbelungen bzw. Turbulenzen in den Luftkanälen vermieden und ein sehr hoher Luftdurchsatz in den Luftkanälen und eine sehr gute Wärmeabfuhr bewirkt werden. Auch bei diesem derart konstruierten Automatisierungsgerät wird eine ausreichende Entwärmung nur dann ermöglicht, wenn der Träger z. B. in einem Schaltschrank horizontal angeordnet ist.

Ein Anwender entscheidet gewöhnlich im Rahmen einer Projektierung derartiger Automatisierungsgeräte, welche Stromversorgungsbaugruppe für die zur Lösung einer Automatisierungsaufgabe erforderlichen Baugruppen geeignet ist, damit diese Baugruppen, beispielsweise Baugruppen in Form von CPU-, Kommunikations-, Ein-/Ausgabe- oder sonstigen für das Automatisierungsgerät geeigneten Baugruppen, auch bei Volllast ausreichend mit der entsprechenden elektrischen Leistung versorgt werden können. Dabei prüft eine Projektierungs-Software mittels baugruppenspezifischen Informationen, ob im Hinblick auf die Anzahl der erforderlichen Baugruppen und des dadurch erforderlichen Leistungsbedarfs, bezüglich deren jeweiliger Verlustleistung der vertikal einzubauenden Baugruppen sowie hinsichtlich einer maximal zulässigen Umgebungstemperatur am Einsatzort der erforderliche Ausbau des Automatisierungsgerätes überhaupt zulässig ist. Für den Fall, dass der Ausbau zulässig ist, ist die Projektierung im Hinblick auf die Leistungsbilanzierung abgeschlossen.
Im Rahmen einer Inbetriebnahme des projektierten Automatisierungsgerätes oder im Rahmen einer Änderung der projektierten Hardware-Konfiguration überprüft die CPU-Baugruppe zunächst vor dem eigentlichen Steuerbetrieb zur Lösung der Automatisierungsaufgabe, ob die maximale elektrische Leistung, die von der projektierten Stromversorgungsbaugruppe bei Volllast bereitgestellt werden kann, auch tatsächlich ausreicht, um die Baugruppen ausreichend zu versorgen. Dazu liest die CPU-Baugruppe die in den Baugruppen abgespeicherten Informationen über den jeweiligen Leistungsbedarf bzw. die jeweilige Leistungsaufnahme der Baugruppen aus und berechnet aus diesen Informationen den Gesamt-Leistungsbedarf des Automatisierungsgerätes. Darüber hinaus liest die CPU-Baugruppe die in der Stromversorgungsbaugruppe hinterlegte Information über die maximale Stromabgabe bzw. über die maximale Leistung aus, welche von dieser bereitgestellt werden kann, und vergleicht diese Leistung mit dem Gesamt-Leistungsbedarf des Automatisierungsgerätes. Für den Fall, dass der Gesamt-Leistungsbedarf die maximale Leistung überschreitet, verhindert die CPU-Baugruppe, dass das Automatisierungsgerät "hochläuft" und den Steuerbetrieb (Betriebszustand "RUN") aufnimmt, oder deaktiviert mindestens eine Baugruppe, welche dadurch am Steuerbetrieb nicht teilnimmt. Für den Fall, dass das Automatisierungsgerät mehrere Stromversorgungsbaugruppen aufweist, ermittelt die CPU-Baugruppe selbstverständlich die maximal mögliche Gesamt-Leistungsabgabe aus der in jeder Stromversorgungsbaugruppe hinterlegten Information über die maximale Leistungsabgabe der jeweiligen Stromversorgungsbaugruppe.

Ein störungsfreier Betrieb des projektierten Automatisierungsgerätes bei Volllast ist - wie bereits erwähnt - allerdings nur dann gewährleistet, wenn eine ausreichende Wärmeabfuhr sichergestellt ist. Dies bedeutet, dass aufgrund des konstruktiven Aufbaus bekannter Automatisierungsgeräte der Träger horizontal bzw. die Baugruppen vertikal in einem Schaltschrank montiert oder an einem sonstigen geeigneten Aufstellort positioniert bzw. angeordnet werden müssen. Für den Fall, dass ein Anwender die Baugruppen in einem Schaltschrank horizontal anordnet, ist eine ausreichende Wärmeabfuhr nicht mehr gewährleistet, wodurch die Baugruppen bei Volllast sich überhitzen und ausfallen können.

Aus der EP 2 149 956 A1 ist bekannt, die Stromversorgungsmodule in Form von Quellenmodulen und die weiteren Module in Form von Senken-Modulen mit Kennzeichnungsmitteln zu versehen, die im Hinblick auf die Quellenmodule deren jeweilige Leistungskapazität bzw. Leistungsabgabe und im Hinblick auf die Senken-Module deren jeweiligen Leistungsbedarf repräsentieren. Aufgrund dieser Kennzeichnungsmittel ist eine Leistungsbilanzierung sowohl auf Strom abgebende als auch auf Strom aufnehmende Module bzw. Baugruppen möglich. Maßnahmen zur Verhinderung einer Überlast aufgrund eines z. B. nicht ordnungs- bzw. sachgemäßen Einbaus in einen Schaltschrank und einer dadurch resultierenden verminderten Luftkonvektion sind nicht vorgesehen.

Ein Gerät gemäß dem Oberbegriff des Anspruchs 1 ist aus der US 2002/0195953 A1 bekannt. Dort reduziert die Stromversorgung in Abhängigkeit der Einbaulage die Abgabeleistung.

Der Erfindung liegt die Aufgabe zugrunde, ein Automatisierungsgerät der eingangs genannten Art zu verbessern.

Diese Aufgabe wird durch die im kennzeichnenden Teil des Anspruchs 1 angegebenen Maßnahmen gelöst.

Die Erfindung geht von der Idee aus, eine "lageabhängige" Leistungsbilanzierung bewerkstelligen zu können. Unabhängig von der Einbaulage des Automatisierungsgerätes, z. B. unabhängig davon, ob das Automatisierungsgerät horizontal oder vertikal eingebaut oder aufgestellt wird, ist sichergestellt, dass z. B. der Betrieb des Automatisierungsgerätes oder mindestens eines der Module des Automatisierungsgerätes verhindert wird, falls ein Schwellwert bzw. eine zulässige Leistungsabgabe erreicht oder überschritten wird. Beispielsweise kann im Falle eines horizontalen Einbaus des Trägers des Automatisierungsgerätes in einen Schaltschrank und einer vertikalen Montage von bekannten Baugruppen auf den Träger der Schwellwert entsprechend der maximalen Leistung gewählt werden, welche die Stromversorgungsbaugruppe bei Volllast bereitstellen kann; denn in dieser Einbaulage ist aufgrund der Konstruktion der Baugruppen eine gute Luftkonvektion und Wärmeabfuhr gewährleistet, so dass davon ausgegangen werden kann, dass auch im Volllastbetrieb der Baugruppen eine Überhitzung vermieden wird.

Wird dagegen der Träger vertikal eingebaut, was bedeutet, dass die Baugruppen horizontal angeordnet sind, so ist in dieser Einbaulage eine gute Luftkonvektion und Wärmeabfuhr nicht mehr gegeben. Es muss daher in diesem Fall davon ausgegangen werden, dass im Volllastbetrieb die Baugruppen überhitzen, falls der Schwellwert entsprechend der maximalen Leistung, welche die Stromversorgungsbaugruppe bei Volllast bereitstellen kann, gewählt werden würde. Um dies zu vermeiden, wird in dieser Einbaulage der Schwellwert geringer gewählt, beispielsweise setzt die CPU-Baugruppe den Schwellwert bzw. die zulässige Leistungsabgabe entsprechend dem 0,6fachen der maximalen Leistung, welche die Stromversorgungsbaugruppe bei Volllast bereitstellen kann. Ermittelt die CPU-Einheit einen Gesamt-Leistungsbedarf der Baugruppen, welcher über diesem Schwellwert liegt, so leitet die CPU-Einheit für mindestens eine der Baugruppen des Automatisierungsgerätes Maßnahmen zur Reduzierung des Leistungsbedarfs ein. Der Schwellwert ist so gewählt, dass ein störungsfreier Betrieb des Automatisierungsgerätes trotz verminderter Wärmeabfuhr gewährleistet ist und die Baugruppen sich nicht überhitzen. Für den Fall, dass der Leistungsbedarf der restlichen Baugruppen immer noch über diesem Schwellwert liegt, deaktiviert die CPU-Einheit wiederum eine der weiteren Baugruppen, wobei es vorkommen kann, dass das Automatisierungsgerät den Steuerbetrieb nicht aufnimmt, weil die CPU-Baugruppe das Automatisierungsgerät in einen Betriebszustand "STOPP" schaltet.

In einer Ausgestaltung der Erfindung ist vorgesehen, dass das Erreichen oder Überschreiten des Schwellwertes angezeigt wird, wodurch ein Anwender geeignete Maßnahmen einleiten kann, um eine Überlast aufgrund der Einbaulage zu verhindern.

Weitere Ausgestaltungen der Erfindung ergeben sich aus den weiteren Unteransprüchen.

Anhand der Zeichnung, in der ein Ausführungsbeispiel der Erfindung veranschaulicht ist, werden im Folgenden die Erfindung, deren Ausgestaltungen sowie Vorteile näher erläutert.

Es zeigen:
- Figur 1: in vereinfachter Darstellung einen mit Automatisierungsgeräten bestückten Schaltschrank und
- Figur 2: eine an sich bekannte Baugruppe eines Automatisierungsgerätes.

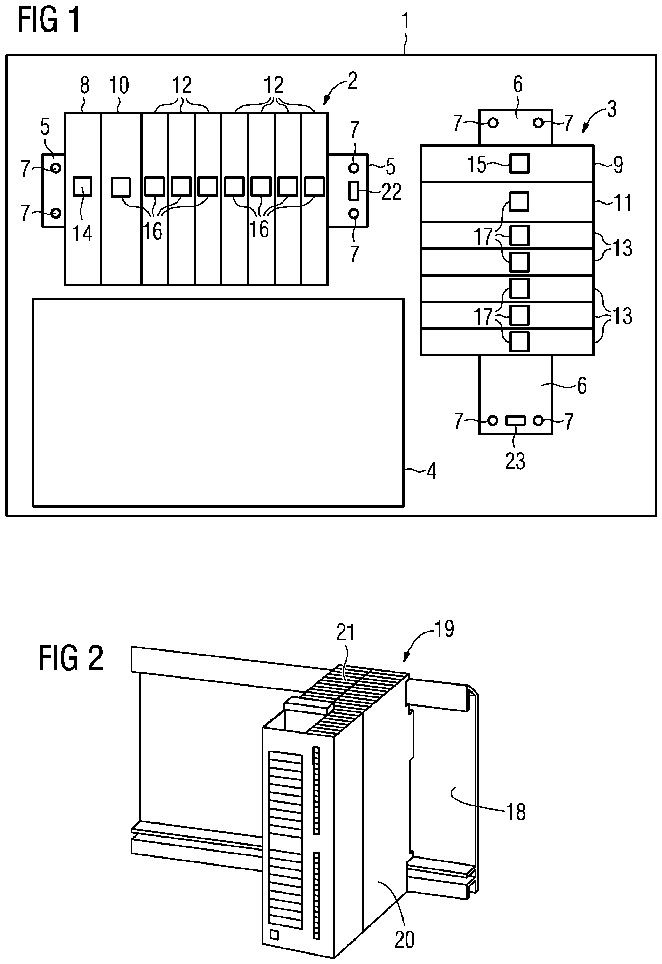

In Figur 1 ist mit 1 ein Schaltschrank bezeichnet, in welchem ein erstes und ein zweites Automatisierungsgerät 2, 3 und weitere elektrische und elektronische Bestandteile 4 montiert sind. Die Automatisierungsgeräte 2, 3 weisen mehrere Module auf, die im vorliegenden Beispiel als Baugruppen ausgebildet sind. Diese Baugruppen sind nebeneinander auf Trägern 5, 6, z. B. Träger in Form von Hutschienen, aufgeschwenkt und nach dem Aufschwenken mittels hier nicht dargestellten Schraubverbindungen an diesen Trägern 5, 6 gesichert. Die Träger 5, 6 weisen jeweils vier Bohrungen 7 auf, in welche ebenfalls hier nicht dargestellte Schraubverbindungen zum Befestigen bzw. Montieren der Träger 5, 6 in den Schaltschrank 1 eingeführt werden. Jedes der Automatisierungsgeräte 2, 3 weist eine Stromversorgungsbaugruppe 8, 9, eine CPU-Baugruppe 10, 11 sowie weitere für den Betrieb der Automatisierungsgeräte 2, 3 erforderliche Peripherie-, Funktions- sowie Kommunikationsbaugruppen 12, 13 auf, wobei die Baugruppen über einen Bus oder über sonstige geeignete Verbindungen Informationen austauschen. Selbstverständlich können beide Automatisierungsgeräte 2, 3 ebenfalls über Kommunikationsleitungen miteinander verbunden oder die beiden Träger 5, 6 lediglich mit Baugruppen eines Automatisierungsgerätes versehen sein, wobei im letztgenannten Fall jeder der Träger 5, 6 eine so genannte Anschaltbaugruppe aufweist, welche über geeignete Kommunikationsverbindungen miteinander gekoppelt sind.

Jede der Stromversorgungsbaugruppen 8, 9 weist einen Speicher 14, 15 auf, in welchen jeweils die maximale Strom- bzw. Leistungsabgabe der jeweiligen Stromversorgungsbaugruppen 8, 9 hinterlegt ist. Die weiteren Baugruppen der Automatisierungsgeräte 2, 3, also die CPU-Baugruppen 10, 11 und die Peripherie-, Funktions- sowie Kommunikationsbaugruppen 12, 13, sind ebenfalls mit einem Speicher 16, 17 versehen, in welchen der Strom- bzw. der Leistungsbedarf der jeweiligen Baugruppe hinterlegt ist, welcher während eines Volllastbetriebs von den Baugruppen benötigt wird.

Sowohl die Stromversorgungen 8, 9 als auch die weiteren Baugruppen 10, 11, 12, 13 weisen zur Entwärmung ihrer Bauteile Öffnungen auf der Unterseite und der Oberseite einer Gehäusekapsel auf. Dazu wird im Folgenden auf Figur 2 verwiesen, in welcher eine auf einem Träger 18 angeordnete, an sich bekannte Baugruppe 19 dargestellt ist. Die Entwärmung erfolgt im Wesentlichen durch Konvektion in der Art und Weise, dass Luft durch Öffnungen auf der Unterseite einer Gehäusekapsel 20 über die elektrischen und elektronischen Bauteile der Baugruppe und schließlich durch eine Öffnung 21 auf der Oberseite der Gehäusekapsel 20 strömt, wobei die durch das Gehäuse strömende Luft den Bauteilen Wärme entzieht. Aufgrund einer derartigen Konstruktion der Baugruppe 19 wird eine ausreichende Entwärmung während des Steuerbetriebs nur dann ermöglicht, wenn der Träger 18 horizontal in einem Schaltschrank bzw. die Baugruppe 19 vertikal auf dem Träger 18 angeordnet ist.

Nach dem Einschalten der Automatisierungsgeräte 2, 3 (Figur 1) oder nach einer Änderung der Hardware-Konfiguration der Automatisierungsgeräte 2, 3, im Rahmen dessen eine neue Baugruppe hinzugefügt oder eine Baugruppe ausgetauscht wird, bewerkstelligen die jeweiligen CPU-Baugruppen 10, 11 der Automatisierungsgeräte 2, 3 zunächst eine "lageabhängige" Leistungsbilanzierung, welche die CPU-Baugruppen 10, 11 vor dem eigentlichen Steuerbetrieb ausführen.
Die CPU-Baugruppe 10 liest dazu die Speicher 14, 16 aller Baugruppen 8, 10, 12 aus und prüft mittels der dort hinterlegten Informationen im Hinblick auf die maximale Leistungsabgabe der Stromversorgungsbaugruppe 8 und den Leistungsbedarf der jeweiligen Baugruppen 8, 10, 12 sowie unter Berücksichtigung der Einbaulage des Trägers 5 bzw. der Baugruppen 8, 10, 12, ob eine zulässige Leistungsabgabe der Stromversorgungsbaugruppe 8 ausreichend ist, den Gesamt-Leistungsbedarf dieser Baugruppen 8, 10, 12 zu decken. Aufgrund dessen, dass ein Lagesensor 22 der CPU-Baugruppe 10 die Einbaulage des Trägers 5 bzw. der Baugruppen 8, 10, 12 der CPU-Baugruppe 10 übermittelt und diese dadurch erkennt, dass der Träger 5 horizontal eingebaut ist bzw. dass die Baugruppen 8, 10, 12 in einer vertikalen Einbaulage montiert sind, bestimmt die CPU-Baugruppe 10 die maximale Leistungsabgabe der Stromversorgungsbaugruppe 8 als Schwellwert, d. h. als zulässige Leistungsabgabe. Diese maximale Leistungsabgabe vergleicht die CPU-Baugruppe 10 mit dem Gesamt-Leistungsbedarf des Automatisierungsgerätes 2, wobei für den Fall, dass dieser die maximale Leistungsabgabe überschreitet, die CPU-Baugruppe 10 leistungsbeschränkende Maßnahmen, d. h. Maßnahmen zur Reduzierung des Leistungsbedarfs, für mindestens eine der Baugruppen 12 einleitet. Beispielsweise schaltet die CPU-Baugruppe 10 eine der Baugruppen 12 ab oder schaltet diese oder alle Baugruppen in einen Betriebszustand "STOPP", wobei in allen Fällen der Steuerbetrieb nicht aufgenommen wird.
Für den Fall, dass die maximale Leistungsabgabe nicht überschritten wird, wovon gewöhnlich aufgrund des ordnungsgemäßen horizontalen Einbaus des Automatisierungsgerätes 2 und der konstruktiven Maßnahmen der Baugruppen 8, 10, 12 hinsichtlich der Wärmeabfuhr (Figur 2) ausgegangen werden kann, wechselt die CPU-Baugruppe 10 des Automatisierungsgerätes 2 in den Steuerbetrieb.

In der entsprechenden Art und Weise bewerkstelligt die CPU-Baugruppe 11 eine "lageabhängige" Leistungsbilanzierung hinsichtlich des Automatisierungsgerätes 3 vor der Aufnahme des Steuerbetriebs. Die CPU-Baugruppe 11 liest die Speicher 15, 17 aller Baugruppen 9, 11, 13 aus und prüft - wie beschrieben - ob die maximale Leistungsabgabe der Stromversorgungsbaugruppe 9 ausreicht, um den Gesamt-Leistungsbedarf der Baugruppen 9, 11, 13 zu decken. Im Unterschied zu dem Automatisierungsgerät 2 erkennt die CPU-Baugruppe 11 des Automatisierungsgerätes 3 aufgrund eines Signals eines Lagesensors 23, dass der Träger 5 vertikal eingebaut ist bzw. dass die Baugruppen 9, 11, 13 in einer horizontalen Einbaulage montiert sind. Diese Einbaulage und die konstruktive Ausgestaltung der Baugruppen 9, 11, 13 bezüglich der Wärmeabfuhr bedeuten, dass die Baugruppen 9, 11, 13 überhitzen könnten, falls die Stromversorgungsbaugruppe 9 ihre maximale Leistung abgeben würde, um den Gesamt-Leistungsbedarf der Baugruppen 9, 11, 13 zu decken. Die CPU-Baugruppe 11 gibt deshalb als Schwellwert, d. h. als zulässige Leistungsabgabe, das 0,6fache der maximalen Leistungsabgabe der Stromversorgungsbaugruppe 8 vor, wobei dieser Schwellwert so gewählt ist, dass die Baugruppen 9, 11, 13 in der horizontalen Einbaulage bei einer Umgebungstemperatur von 65 °C betrieben werden können, ohne dass sich die Baugruppen 9, 11, 13 überhitzen.
Für den Fall, dass der Gesamt-Leistungsbedarf der Baugruppen 9, 11, 13 die zulässige Leistungsabgabe überschreitet, leitet - wie beschrieben - die CPU-Baugruppe 11 leistungsbeschränkende Maßnahmen für mindestens eine der Baugruppen 13 ein. Für den Fall, dass die zulässige Leistungsabgabe nicht überschritten wird, wechselt die CPU-Baugruppe 11 des Automatisierungsgerätes 3 in den Steuerbetrieb.

Die Lagesensoren 22, 23 brauchen selbstverständlich nicht an den Trägern 5, 6 montiert sein, sondern können auch Bestandteil von einer der Baugruppen, vorzugsweise Bestandteil der CPU- oder Stromversorgungsbaugruppe, sein.

## Patentansprüche

1. Automatisierungsgerät, welches mehrere Module (8, 10, 12; 9, 11, 13) aufweist, wobei mindestens ein erstes Modul (8; 9) zur Versorgung der weiteren Module (10, 12; 11, 13) mit elektrischer Leistung und ein zweites Modul (10; 11) zur Ermittlung des Gesamt-Leistungsbedarfs des Automatisierungsgerätes vorgesehen ist, das mit einem Lagesensor (22; 23) versehen ist, welcher die Lage des Automatisierungsgerätes an einem Einbau- oder Aufstellort des Automatisierungsgerätes erfasst, wobei das zweite Modul (10; 11) den Gesamt-Leistungsbedarf mit einem Schwellwert vergleicht und in Abhängigkeit des Vergleichsergebnisses Maßnahmen zur Reduzierung des Leistungsbedarfs mindestens eines der weiteren Module (10, 12; 11, 13) einleitet,
**dadurch gekennzeichnet, dass** das zweite Modul (10; 11) dazu ausgebildet ist, vor dem Hochlauf des Automatisierungsgerätes den Gesamt-Leistungsbedarf aus den in den weiteren Modulen (10, 12; 11, 13) hinterlegten Informationen über den Leistungsbedarf des jeweiligen Moduls (10, 12; 11, 13) zu ermitteln, wobei das zweite Modul (10, 11) die Informationen aus den Modulen (10, 12; 11, 13) ausliest, und das zweite Modul (10, 11) ferner dazu ausgebildet ist, in Abhängigkeit der Lage des Automatisierungsgerätes den Schwellwert vorzugeben bzw. zu bestimmen.

2. Automatisierungsgerät nach Anspruch 1, **dadurch gekennzeichnet, dass** das zweite Modul (10; 11) in einer ersten Lage einen ersten Schwellwert und in einer zweiten Lage einen im Vergleich zum ersten Schwellwert kleineren zweiten Schwellwert vorgibt bzw. bestimmt.

3. Automatisierungsgerät nach Anspruch 2, **dadurch gekennzeichnet, dass** der erste Schwellwert der maximalen Leistung des ersten Moduls (8; 9) entspricht.

4. Automatisierungsgerät nach Anspruch 2 oder 3, **dadurch gekennzeichnet, dass** das zweite Modul (10; 11) das Erreichen oder Überschreiten des ersten oder zweiten Schwellwertes anzeigt.

5. Automatisierungsgerät nach einem der Ansprüche 1 bis 4, **dadurch gekennzeichnet, dass** die Module (8, 10, 12; 9, 11, 13) auf einem Träger (5; 6) angeordnete Baugruppen (8, 10, 12; 9, 11, 13) sind, wobei der Träger (5; 6) oder eine der Baugruppen (8, 10, 12; 9, 11, 13) mit dem Lagesensor (22; 23) versehen ist.

6. Automatisierungsgerät nach Anspruch 5, **dadurch gekennzeichnet, dass** das Automatisierungsgerät mehrere mit Baugruppen versehene Baugruppenträger aufweist, wobei jeder Baugruppenträger oder eine Baugruppe jedes Baugruppenträgers mit einem Lagesensor versehen ist.

## Claims

1. Automation device having a plurality of modules (8, 10, 12; 9, 11, 13), at least one first module (8; 9) being intended to supply the other modules (10, 12; 11, 13) with electrical power and a second module (10; 11) being intended to determine the total power requirement of the automation device which is provided with a position sensor (22; 23), which detects the position of automation device at an installation or erection site of the automation device, the second module (10; 11) comparing the total power requirement with a threshold value and initiating measures for reducing the power requirement of at least one of the other modules (10, 12; 11, 13) on the basis of the comparison result, **characterized in that** the second module (10; 11) is designed to determine, before the running up of the automation device, the total power requirement from the information stored in the other modules (10, 12; 11, 13) relating to the power requirement of the respective module, the second module (10, 11) reading out the information from the modules (10, 12; 11, 13), and the second module (10, 11) being further designed to predefine or determine the threshold value on the basis of the position of the automation device.

2. Automation device according to Claim 1, **characterized in that** the second module (10; 11) predefines or determines a first threshold value in a first position and predefines or determines a second threshold value which is smaller than the first threshold value in a second position.

3. Automation device according to Claim 2, **characterized in that** the first threshold value corresponds to the maximum power of the first module (8; 9).

4. Automation device according to Claim 2 or 3, **characterized in that** the second module (10; 11) indicates when the first or second threshold value is reached or exceeded.

5. Automation device according to one of Claims 1 to 4, **characterized in that** the modules (8, 10, 12; 9, 11, 13) are subassemblies (8, 10, 12; 9, 11, 13) arranged on a carrier (5; 6), the carrier (5; 6) or one of the subassemblies (8, 10, 12; 9, 11, 13) being provided with the position sensor (22; 23).

6. Automation device according to Claim 5, **characterized in that** the automation device has a plurality of mounting racks provided with subassemblies, each mounting rack or a subassembly of each mounting rack being provided with a position sensor.

## Revendications

1. Appareil d'automatisation qui a plusieurs modules (8, 10, 12 ; 9, 11, 13), au moins un premier module (8 ; 9) étant prévu pour l'alimentation des autres modules (10, 12 ; 11, 13) en puissance électrique, et un deuxième module (10 ; 11) pour la détermination du besoin de puissance totale de l'appareil d'automatisation, lequel est pourvu d'un capteur (22 ; 23) de position qui détecte la position de l'appareil d'automatisation en un emplacement de montage ou d'installation de l'appareil d'automatisation, le deuxième module (10 ; 11) comparant le besoin de puissance totale à une valeur de seuil et déclenchant, en fonction du résultat de la comparaison, des mesures de réduction du besoin de puissance d'au moins l'un des autres modules (10, 12 ; 11, 13),
**caractérisé en ce que** le deuxième module (10 ; 11) est constitué pour déterminer, avant le démarrage de l'appareil d'automatisation, le besoin de puissance totale à partir des informations sur le besoin de puissance du module (10, 12 ; 11, 13), respectif mémorisé dans les autres modules 10, 12 ; 11, 13), le deuxième module (10 ; 11) lisant les informations des modules 10, 12 ; 11, 13), et le deuxième module (10 ; 11) étant constitué, en outre, pour prescrire ou définir la valeur de seuil en fonction de la position de l'appareil d'automatisation.

2. Appareil d'automatisation suivant la revendication 1, **caractérisé en ce que** le deuxième module (10 ; 11) prescrit ou détermine, dans une première position, une première valeur de seuil, et dans une deuxième position, une deuxième valeur de seuil plus petite que la première valeur de seuil.

3. Appareil d'automatisation suivant la revendication 2, **caractérisé en ce que** la première valeur de seuil correspond à la puissance maximale du premier module (8 ; 9).

4. Appareil d'automatisation suivant la revendication 2 ou 3, **caractérisé en ce que** le deuxième module (10 ; 11) indique que la première ou la deuxième valeur de seuil est atteinte ou dépassée.

5. Appareil d'automatisation suivant l'une des revendications 1 à 4, **caractérisé en ce que** les modules (8, 10, 12 ; 9, 11, 13) sont des composants (8, 10, 12 ; 9, 11, 13) disposés sur un support (5 ; 6), le support (5 ; 6) où l'un des composants (8, 10, 12 ; 9, 11, 13) étant pourvu d'un capteur (22 ; 23) de position.

6. Appareil d'automatisation suivant la revendication 5, **caractérisé en ce que** l'appareil d'automatisation a plusieurs supports de composants pourvus de composants, chaque support de composant ou un composant de chaque support de composant, étant pourvu d'un capteur de position.
